# EUROPEAN PATENT APPLICATION

(11) **EP 4 803 676 A1**
(43) Date of publication of application: **09.09.2026**
(21) Application number: 24885853.2
(22) Date of filing: 31.10.2024
(51) Int. Cl.: C30B 29/38, C30B 25/04, C30B 25/18, C30B 33/10, H01L 21/20, H01L 21/205, H10H 20/825

(54) **SEMICONDUCTOR SUBSTRATE, METHOD FOR MANUFACTURING SEMICONDUCTOR SUBSTRATE, METHOD FOR MANUFACTURING SEMICONDUCTOR DEVICE, SEMICONDUCTOR DEVICE, AND LIGHT-EMITTING ELEMENT**

(30) Priority: 31.10.2023 JP 2023187030; 31.10.2023 JP 2023187031
(71) Applicant: Kyocera Corporation, Kyoto-shi, Kyoto 612-8501 (JP)
(72) Inventor: KAMIKAWA, Takeshi, Kyoto-shi, Kyoto 612-8501 (JP); AOKI, Yuta, Kyoto-shi, Kyoto 612-8501 (JP); SUDA, Noboru, Kyoto-shi, Kyoto 612-8501 (JP); OGURA, Hiroyuki, Kyoto-shi, Kyoto 612-8501 (JP); YAMASHITA, Fumio, Kyoto-shi, Kyoto 612-8501 (JP); MISHIMA, Kosuke, Kyoto-shi, Kyoto 612-8501 (JP); TADA, Tatsuo, Kyoto-shi, Kyoto 612-8501 (JP)
(74) Representative: Viering, Jentschura & Partner mbB Patent- und Rechtsanwälte
(86) International application number: PCT/JP2024/038981
(87) International publication number: WO 2025/095087

(57) **Abstract**

A semiconductor substrate includes: a template substrate; and a first semiconductor portion located on an upper side of the template substrate, and including a nitride semiconductor. The first semiconductor portion includes a first wing portion, a void is located between the first wing portion and the template substrate, the first wing portion includes a plurality of protrusions protruding downward, and at least one of the plurality of protrusions has a tapered shape with an inclined surface inclined with respect to a thickness direction of the template substrate.

## Description

### TECHNICAL FIELD

The present disclosure relates to a semiconductor substrate and the like.

### BACKGROUND OF INVENTION

By forming a mask pattern where a nitride semiconductor layer does not grow on a template substrate including a heterogeneous substrate and a seed layer, and laterally growing the nitride semiconductor layer on the upper side of the mask portion starting from the seed layer exposed at the opening portion where the mask portion is absent, the defect density of the nitride semiconductor layer on the upper side of the mask portion can be reduced (Patent Document 1).

### CITATION LIST

### PATENT LITERATURE

Patent Document 1: JP 2013-251304A

### SUMMARY

### SOLUTION TO PROBLEM

A semiconductor substrate includes: a template substrate; and a first semiconductor portion located on an upper side of the template substrate, and including a nitride semiconductor. The first semiconductor portion includes a first wing portion, a void is located between the first wing portion and the template substrate, the first wing portion includes a plurality of protrusions protruding downward, and at least one of the plurality of protrusions has a tapered shape with an inclined surface inclined with respect to a thickness direction of the template substrate.

### BRIEF DESCRIPTION OF THE DRAWINGS

FIG. 1 is a plan view illustrating a configuration of a semiconductor substrate according to a present embodiment.
FIG. 2 is a sectional view illustrating a configuration of the semiconductor substrate according to the embodiment.
FIG. 3 is a sectional view illustrating a configuration of the semiconductor substrate according to the embodiment.
FIG. 4 is a perspective view illustrating a configuration of a protrusion.
FIG. 5 is a sectional view illustrating a configuration of the semiconductor substrate according to the embodiment.
FIG. 6 is a sectional view illustrating a configuration of the semiconductor substrate according to the embodiment.
FIG. 7 is a flowchart illustrating a method for manufacturing the semiconductor substrate according to the present embodiment.
FIG. 8 is a sectional view illustrating the method for manufacturing the semiconductor substrate according to the present embodiment.
FIG. 9 is a sectional view illustrating the method for manufacturing the semiconductor substrate according to the present embodiment.
FIG. 10 is a block diagram illustrating a manufacturing device of the semiconductor substrate according to the present embodiment.
FIG. 11 is a flowchart illustrating a method for manufacturing the semiconductor device according to the present embodiment.
FIG. 12 is a sectional view illustrating the method for manufacturing the semiconductor device according to the present embodiment.
FIG. 13 is a sectional view illustrating the method for manufacturing the semiconductor device according to the present embodiment.
FIG. 14 is a sectional view illustrating a method for manufacturing a template substrate.
FIG. 15 is a sectional view illustrating a method for forming a GaN crystal portion of an initial wing portion by ELO.
FIG. 16 is a sectional view illustrating a method for manufacturing a semiconductor substrate according to Example 1.
FIG. 17 is a plan view illustrating the semiconductor substrate according to Example 1.
FIG. 18 is a sectional view illustrating a method for manufacturing a semiconductor device according to Example 1.
FIG. 19 illustrates a measurement result of a nitride semiconductor produced using the semiconductor substrate according to Example 1.
FIG. 20 is a sectional view illustrating the method for manufacturing the semiconductor substrate according to Example 1.
FIG. 21 is a sectional view illustrating a method for manufacturing a semiconductor substrate according to Example 2.
FIG. 22 is a sectional view illustrating a method for manufacturing a semiconductor substrate according to Example 3.
FIG. 23 is a sectional view illustrating a method for manufacturing a semiconductor substrate according to Example 4.
FIG. 24 is a sectional view illustrating the method for manufacturing the semiconductor substrate according to Example 4.
FIG. 25 is a sectional view illustrating a method for manufacturing a semiconductor substrate according to Example 5.
FIG. 26 is a sectional view illustrating the method for manufacturing the semiconductor substrate according to Example 5.
FIG. 27 is a sectional view illustrating a method for manufacturing a semiconductor substrate according to Example 6.
FIG. 28 is a schematic view illustrating a configuration of an electronic device according to Example 7.
FIG. 29 is a sectional view illustrating a configuration of a protrusion of each Example.
FIG. 30 is a flowchart illustrating the method for manufacturing the semiconductor substrate according to the present embodiment.
FIG. 31 is a sectional view illustrating a configuration example of the semiconductor device according to the present embodiment.
FIG. 32 is a sectional view illustrating a configuration example of the semiconductor device according to the present embodiment.

### DESCRIPTION OF EMBODIMENTS

### Embodiment

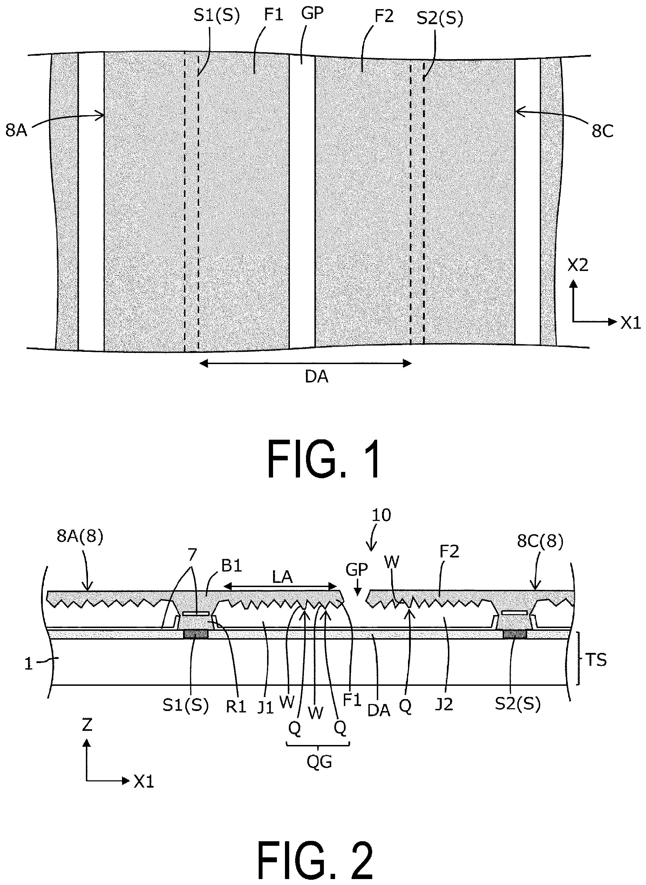

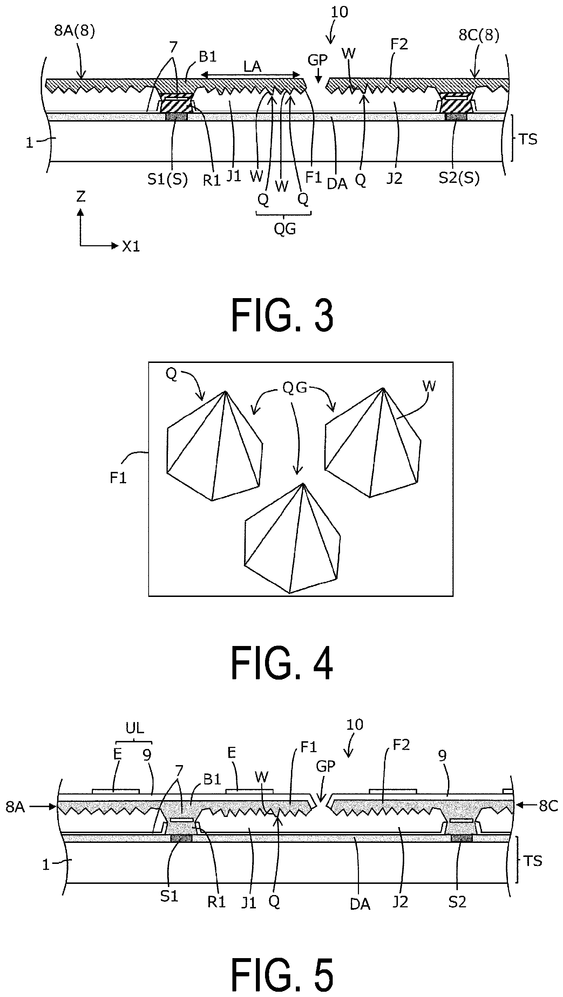

FIG. 1 is a plan view illustrating a configuration of a semiconductor substrate according to the present embodiment. FIGs. 2 and 3 are sectional views illustrating a configuration of the semiconductor substrate according to the present embodiment. As illustrated in FIGs. 1 to 3, a semiconductor substrate 10 includes a template substrate TS, and a first semiconductor portion 8A located on the upper side of the template substrate TS and including a nitride semiconductor. The first semiconductor portion 8A includes a first wing portion F1, and a first void J1 is located between the first wing portion F1 and the template substrate TS. The first wing portion F1 includes a plurality of protrusions Q protruding downward, and at least some (one) of the plurality of protrusions has a tapered shape with an inclined surface W inclined with respect to a thickness direction Z of the template substrate TS.

The first wing portion F1 of the semiconductor substrate 10 is separated from the template substrate TS and includes the plurality of protrusions Q protruding downward, and therefore when a light-emitting functional layer is formed on the upper side of the first wing portion F1, the light extraction efficiency from the bottom surface (back surface) is increased. Specifically, in comparison with a case where the back surface is flat, reflected light toward the functional layer side is reduced, and the amount of light emitted to the outside increases. Since the first wing portion F1 of the semiconductor substrate 10 is separated from the template substrate TS and includes the plurality of protrusions Q protruding downward, the internal stress is reduced. In this manner, a high-quality functional layer (including an active layer) can be formed on the upper side of the first wing portion F1.

The first semiconductor portion (first semiconductor layer) 8A includes, as a main component, a nitride semiconductor. The nitride semiconductor may be represented, for example, by AlxGayInzN (0 ≤ x ≤ 1;0 ≤ y ≤ 1; 0 ≤ z ≤ 1; x + y + z = 1), and specific examples may include a GaN-based semiconductor, AlN (aluminum nitride), InAlN (indium aluminum nitride), and InN (indium nitride). The GaN-based semiconductor is a semiconductor containing gallium (Ga) atoms and nitrogen (N) atoms, and typical examples may include GaN, AlGaN, AlGaInN, and InGaN.

The first semiconductor portion 8A may be either a doped type (e.g., n-type containing a donor) or a non-doped type. The first semiconductor portion 8A may contain an n-type dopant at a concentration higher than 5 × 10¹⁷/cm³, in which case the etching rate can be increased. The term "semiconductor substrate" refers to a substrate including a semiconductor, and a main substrate 1 included in the template substrate TS may or may not include a semiconductor (such as silicon and silicon carbide). An example of the main substrate 1 that does not include a semiconductor is a sapphire substrate. The template substrate TS may also be referred to as a growth substrate. The main substrate 1 may be a self-supporting substrate (wafer). A seed portion S1 can be deposited by a sputtering method. Naturally, a metal organic chemical vapor deposition (MOCVD) method, a molecular beam epitaxy (MBE) method or the like may also be used for deposition. The seed portion S1 may be composed of a gallium nitride film (GaN), an aluminum nitride film (AlN), or a mixed crystal film of gallium and aluminum (e.g., AlGaN, InGaN, AlInGaN). A buffer portion (e.g., AlN single layer, multilayer of AlN and AlGaN) may be provided between the main substrate 1 and the seed portion S1. Examples of configurations may include a sapphire substrate (main substrate)/AlN/GaN (seed portion), a sapphire substrate (main substrate)/AlN/AlGaN/GaN (seed portion), and a silicon substrate (main substrate)/Al/AlN/GaN (seed portion).

A first direction X1 may be the a-axis direction (<11-20> direction) of the first semiconductor portion 8A (a nitride semiconductor such as GaN). A second direction X2 may be the m-axis direction (<1-100> direction) of the first semiconductor portion 8A. A thickness direction Z of the semiconductor substrate 10 (the thickness direction of the template substrate TS) may be the c-axis direction (<0001> direction) of the first semiconductor portion 8A.

The first semiconductor portion 8A may be formed by an epitaxial lateral overgrowth (ELO) method starting from the seed portion S1, and may include a first raised portion R1 joined to the seed portion S1, and a first base portion B1 connected to the first raised portion R1 and the first wing portion F1. In the first semiconductor portion 8A, the base portion B1 located on the upper side of the seed portion S1 serves as a dislocation inheritance region with a high density of threading dislocations, and the first wing portion F1 located on the upper side of a growth suppression region DA serves as a low-defect portion with a lower threading dislocation density compared to the dislocation inheritance region. A second semiconductor portion 8C may be grown laterally on the upper side of the growth suppression region DA starting from a seed portion S2, and the growth may be stopped before it joins with the first semiconductor portion 8A. The threading dislocation density of the first wing portion F1 may be 5 × 10⁶ dislocations/cm² or less. The first wing portion F1 may have an edge. After the first semiconductor portion 8A and the second semiconductor portion 8C are joined, a gap GP may be formed by removing the junction portion through etching or the like.

As illustrated in FIG. 2, in the semiconductor substrate 10, the first raised portion R1 and the first wing portion F1 may be composed of the same GaN-based semiconductor (e.g., GaN). As illustrated in FIG. 3, in the semiconductor substrate 10, a mixed crystal of a GaN-based semiconductor containing at least one of aluminum (Al) and indium (In) may be exposed on the lower side of the first wing portion F1. The first raised portion R1 and the first wing portion F1 may be composed of different GaN-based semiconductors. For example, the first raised portion R1 may be a GaN crystal, and the first wing portion F1 may be a GaN-based mixed crystal (ternary or quaternary mixed crystal) containing at least one of Al and In. The first wing portion F1 may be an AlGaN base member, an AlInGaN base member, or an InGaN base member.

The +c-plane of the nitride semiconductor may be exposed on the top surface of the first wing portion F1, and the -c-plane of the nitride semiconductor may be exposed on the bottom surface of the first wing portion F1. The +c-plane may be a gallium-polar surface, an aluminum-polar surface, or an indium-polar surface, and the -c-plane may be a nitrogen-polar surface. For example, by visually observing a TEM image of the top surface of the first wing portion F1, the arrangement and spacing of Ga particles and N particles caused by the wurtzite structure can be observed, and thus the shape of the (0001) plane (c-plane) polarity crystal lattice can be observed.
Alternatively, the top surface may be determined to be a gallium-polar surface by visually observing a TEM image of a cross-section in the thickness direction (Z direction) of the top surface of the first wing portion F1 and observing that Ga particles resulting from the wurtzite structure protrude toward the top surface side, for example.

FIG. 4 is an image showing an example of a shape of a protrusion. As illustrated in FIG. 4, each of the plurality of protrusions Q included in the bottom surface (back surface) of the first wing portion F1 has a pyramidal shape (quadrangular pyramidal shape). The inclined surface W of the protrusion Q may be a (10-1-1) plane inclined with respect to the (0001) plane (c-plane). The first wing portion F1 may have a low-defect portion LA with a lower defect density than the first base portion B1, and a protrusion group QG including the plurality of protrusions Q may be located over the entire lower side of the low-defect portion LA of the first wing portion F1. The roughness of the top surface of the first wing portion F1 may be smaller than the roughness of the bottom surface of the first wing portion F1. The roughness of the side surface of the first wing portion F1 may be smaller than the roughness of the bottom surface of the first wing portion F1. The roughness of the side surface of the first raised portion R1 may be smaller than the roughness of the bottom surface of the first wing portion F1.

The dislocations (defects) in the first wing portion F1 can be observed through mapping of the peak shift in Raman scattering spectra or cathodoluminescence (CL) measurement. The dislocation density (defect density) of the first wing portion F1 can be calculated and compared by determining the number of dislocations (defects) observed through the above measurements.
The roughness of the first wing portion F1 can be calculated and compared by determining, for example, the number of protrusions Q per unit area from the results of AFM measurement or from SEM images. The roughness of the first wing portion F1 may be a maximum height roughness Rz measured by AFM, for example. Rz may be a value from 200 nm to 300 nm, or may be a value greater than 300 nm. The roughness can be measured in the same manner for the top surface, bottom surface, and side surface of the first wing portion F1.

The protrusion Q may have various shapes as long as the shape protrudes downward with an inclined surface inclined with respect to the thickness direction of the template substrate TS. The protrusion Q may have a conical shape, and the cross-sectional shape of the protrusion Q having the conical shape in the thickness direction (Z direction) of the template substrate TS may be trapezoidal. The cross-sectional shape of the protrusion Q in a direction (X1-X2 plane direction) perpendicular to the thickness direction of the template substrate TS may be polygonal. In this case, the shape may not be the exact polygonal shape, and may include polygonal shapes with rounded vertex portions. The protrusion Q may also have a shape with a rounded lower end portion.

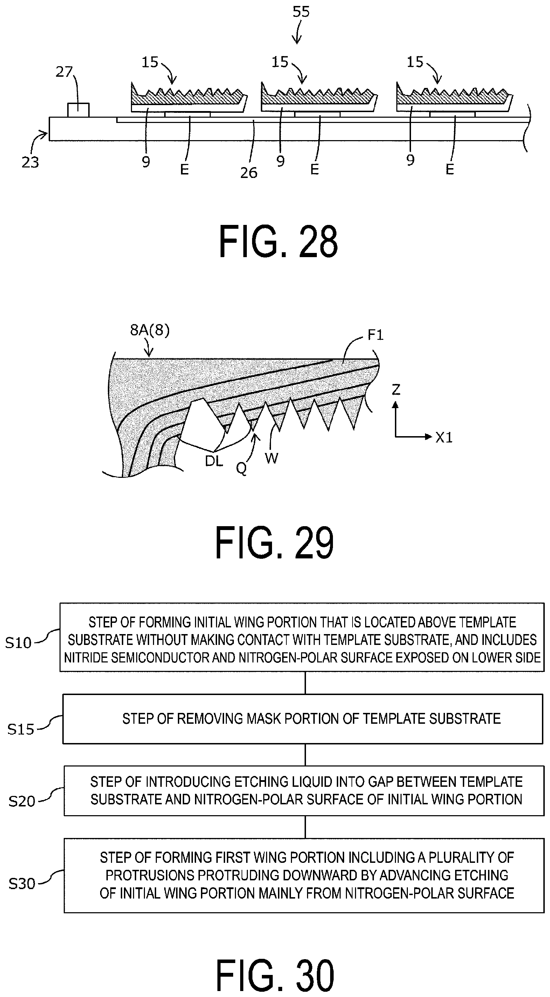

At least one protrusion Q of the protrusion group QG may have a lower defect density than the first base portion B1. At least one protrusion Q of the protrusion group QG may have a lower defect density than the portion other than the protrusion of the low-defect portion LA of the first wing portion F1. As illustrated in FIG. 29, when the protrusion Q has a conical shape, a linear defect DL may exist inside with a shape connecting one inclined surface to another inclined surface, for example. In this case, the linear defect DL inside the protrusion Q may be inclined with respect to the plane direction (X1-X2 plane direction) of the template substrate TS. The linear defect DL inside the protrusion Q may have a shape extending upward with increasing distance from the first base portion B1 (a shape inclined with respect to the X1-X2 plane in a direction away from the template substrate TS).

In the protrusion group QG, at least two protrusions Q may be separated from or adjacent to each other. In the protrusion group QG, at least two protrusions Q may have different shapes, such as different quadrangular pyramidal shapes, for example. In the protrusion group QG, in the cross-section (along the c-axis) in the up-down direction of at least two protrusions Q, the inclination angles of the inclined surfaces may be different. The inclination angle of the inclined surface may be an angle with respect to the thickness direction of the template substrate TS. In the protrusion group QG, at least two protrusions Q may have different heights. In the protrusion group QG, at least two protrusions Q may have heights such that the protrusion closer to the first base portion B1 is higher, or that the protrusion closer to the first base portion B1 is higher.

The thickness of the first wing portion F1 may be 15 [µm] or less or 8.0 [µm] or less. The plurality of protrusions Q may have a height of 20 [nm] or more, 50 [nm] or more, or 100 [nm] or more. A void J1 may have a ratio of the width (X1 direction dimension) with respect to the height (Z direction dimension, thickness) of 5.0 or more. The height (thickness) of the void J1 may be the distance from the growth suppression region DA to the tip end of the protrusion Q. The height (thickness) of the void J1 may be greater on the first base portion B1 side than on the edge side, for example. The ratio of the thickness of the first wing portion F1 with respect to the thickness of the void J1 may be smaller than 2.0.

The semiconductor substrate 10 may include the second semiconductor portion 8C located on the upper side of the template substrate TS and including a nitride semiconductor, and the second semiconductor portion 8C includes a second wing portion F2. A void J2 is located between the second wing portion F2 and the template substrate TS, and the second wing portion F2 may include the plurality of protrusions Q protruding downward.

The top surface of the template substrate TS may include the growth suppression region DA, and two seed regions S1 and S2 adjacent to each other with the growth suppression region DA therebetween. The growth suppression region DA and the seed regions S1 and S2 may or may not be located on the same plane. The first wing portion F1 and the second wing portion F2 may be located on the upper side of the growth suppression region DA. The first semiconductor portion F1 may include the first raised portion R1 joined to the seed region S1, and the first base portion B1 located on the upper side of the seed region S1. The semiconductor substrate 10 may include a growth suppression film 7 (such as a silicon oxide film or a silicon nitride film), and the growth suppression film 7 may be located between the first raised portion R1 and the first base portion B1, or located at the side surface of the first raised portion R1, or, located on the upper side of the growth suppression region DA.

The material of the growth suppression region DA may be a material obtained by modifying the materials of the two seed regions S1 and S2. The material of the growth suppression region DA may be an oxide of the two seed regions S1 and S2. The materials of the two seed regions S1 and S2 may be aluminum nitride. The material of the growth suppression region DA may be aluminum oxynitride.

The template substrate TS may include the main substrate 1, and the main substrate 1 may be a heterogeneous substrate having a lattice constant different from that of the nitride semiconductor included in the first semiconductor portion 8A. Examples of the main substrate 1 composed of a heterogeneous substrate may include a silicon substrate, a silicon carbide substrate, and a sapphire substrate.

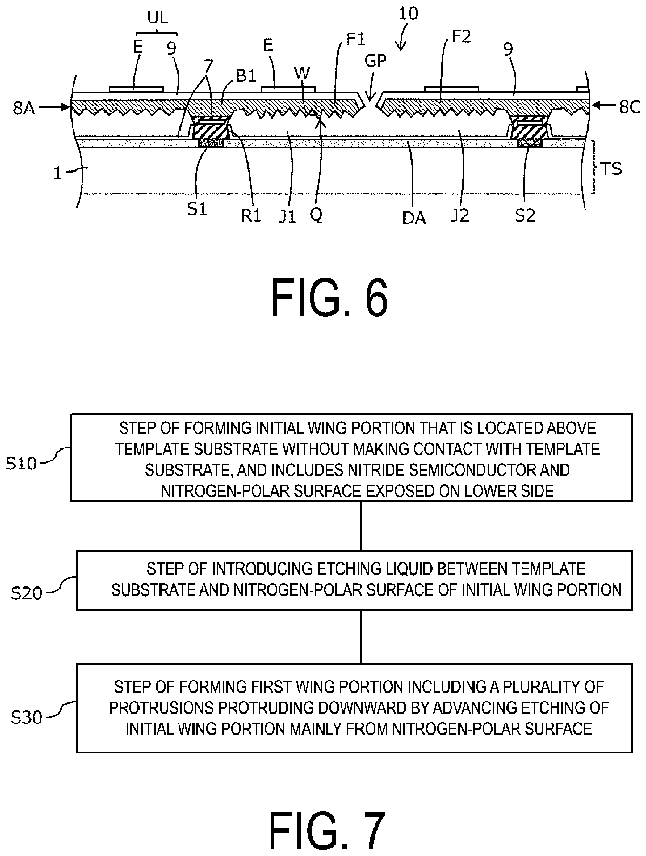

FIGs. 5 and 6 are sectional views illustrating a configuration of the semiconductor substrate according to the present embodiment. As illustrated in FIGs. 5 and 6, the semiconductor substrate 10 may include an upper layer portion UL located on the upper side of the first semiconductor portion 8A. The upper layer portion UL may include a functional layer 9 including an active layer. The functional layer 9 may include an n-type layer and a p-type layer, in addition to the active layer. The functional layer 9 may be a light-emitting layer and may have a GaN-based multiple quantum well structure. The upper layer portion UL may include an electrode E (such as an anode and a cathode) in addition to the functional layer 9.

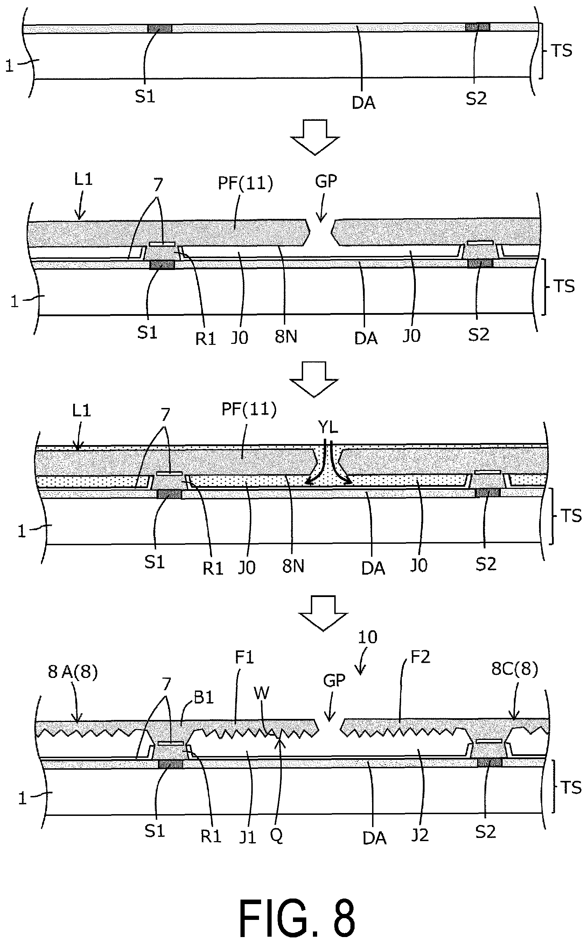

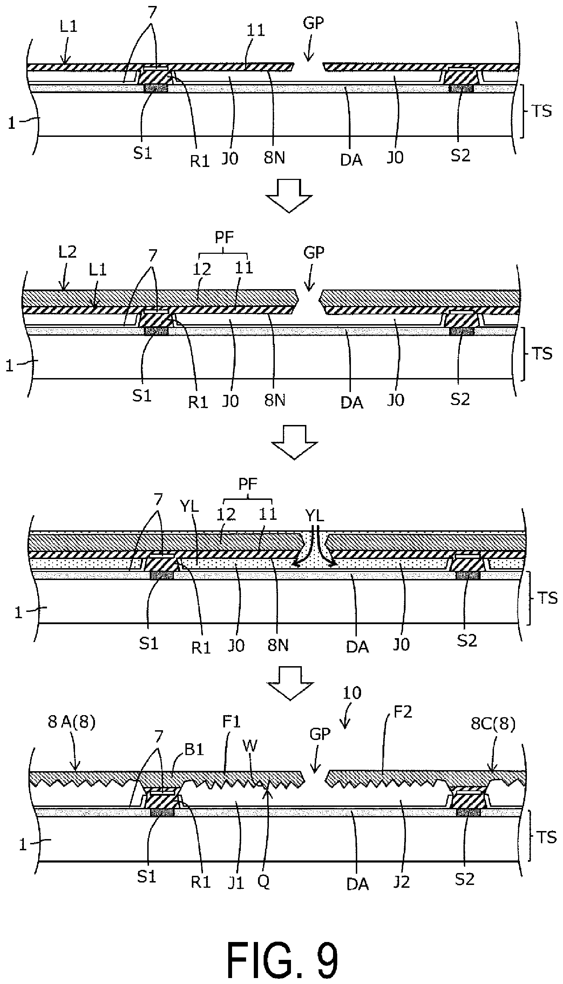

FIG. 7 is a flowchart illustrating a method for manufacturing the semiconductor substrate according to the present embodiment. FIGs. 8 and 9 are sectional views illustrating the method for manufacturing the semiconductor substrate according to the present embodiment. As illustrated in FIGs. 7 to 9, the method for manufacturing the semiconductor substrate according to the present embodiment includes a step S10, a step S20, and a step S30. Step S10 is a step of forming the initial wing portion PF, which is located on the upper side of the template substrate TS without making contact with the template substrate TS, and includes a nitride semiconductor with a nitrogen-polar surface 8N exposed on a lower side. Step S20 is a step of introducing etching liquid YE into a gap J0 between the nitrogen-polar surface 8N of the initial wing portion PF and the template substrate TS. Step S30 is a step of forming the first wing portion F1 including the plurality of protrusions Q protruding downward by advancing etching of the initial wing portion PF mainly from the nitrogen-polar surface 8N (back surface).

The method for manufacturing the semiconductor substrate according to the present embodiment may include a step of removing a mask portion provided in the template substrate TS and serving as the growth suppression region DA. As illustrated in FIG. 29, the step of removing the mask may be step S15 between step S10 of forming the initial wing portion PF and step S20 of introducing the etching liquid YE. The mask portion may be composed of silicon nitride (SiN) or silicon oxide (SiO₂). At step S15, the mask portion can be removed by introducing hydrofluoric acid solution (HF) into the gap J0, for example. The nitrogen-polar surface 8N of the initial wing portion PF and the gap J0 on the upper side of the template substrate TS may be formed through removal of the mask portion using the hydrofluoric acid solution or the like (as a result of mask removal). In this manner, by removing the mask portion before introducing the etching liquid YE, the risk of entry of silicon (Si) into the initial wing portion PF can be reduced, thereby enhancing the quality of the first wing portion F1.

Through the removal step, the height (the length in the Z direction) of the gap J0 can be increased. Thus, at the subsequent step S20, the etching liquid YE can be easily introduced deep into the gap J0 (up to the vicinity of the first raised portion R1), thereby reducing uneven etching in the width direction (the first direction X1) of the wing portion F1. In this manner, the light extraction effect is equalized, and thus a high-quality light-emitting device can be achieved.

The process may include a step of introducing oxidant into a void J0 prior to or simultaneously with step S20. In this manner, a fine oxide film is formed on the nitrogen-polar surface 8N, and protrusions Q can be formed by etching, starting from the locally different etching rates resulting from the oxide film.

In the initial wing portion PF, the bottom surface as the nitrogen-polar surface 8N, the top surface as the Ga-polar surface, and the side surface are simultaneously etched. Among these, the nitrogen-polar surface 8N is substantially selectively etched since the etching rate of the nitrogen-polar surface 8N (bottom surface or back surface) is extremely high. Note that the Ga-polar surface (top surface) is also etched although at a very slow rate, and thus, even if there are slight irregularities or abnormal points on the Ga-polar surface of the initial wing portion PF, the etching can form a smooth (0001) plane (the top surface of the first wing portion F1). In this manner, a highly flat regrowth layer, and a high-yield, high-quality functional layer (device layer including an active layer) may be formed by a MOCVD method on the upper side of the first wing portion F1, for example. Since a thin first wing portion is obtained through the etching of the initial wing portion PF, light emission from the side surface is suppressed in the case where a light-emitting functional layer is formed on the upper side of the first wing portion F1. In this manner, a light-emitting element (semiconductor device) with high light extraction efficiency and a reduced risk of color interference (color mixing) can be obtained.

As illustrated in FIG. 9, the initial wing portion PF may include a GaN crystal portion 11 where the nitrogen-polar surface 8N is exposed, and a GaN mixed crystal portion 12 located on the upper side of the GaN crystal portion 11 and containing at least one of aluminum and indium, and the first wing portion F1 (such as an AlGaN base member, an AlInGaN base member, and an InGaN base member) including all or part of the GaN mixed crystal portion 12 may be formed by removing the GaN crystal portion 11 on the lower layer side by wet etching.

It is difficult to achieve ELO deposition with good crystallinity for a GaN mixed crystal portion such as AlGaN in comparison with a GaN crystal portion, but a low defect and low internal stress GaN mixed crystal portion 12 (the wing portion of a GaN mixed crystal layer L2) can be obtained as the first wing portion F1 by depositing the GaN mixed crystal layer L2 on the GaN crystal layer L1 obtained through ELO deposition starting from the seed region S1, and thereafter removing the wing portion (the GaN crystal portion 11) of the GaN crystal layer L1 as illustrated in FIG. 9. Since the GaN crystal layer L1 includes the first raised portion R1, the first raised portion R1 and the first wing portion F1 (the GaN mixed crystal portion 12) may be composed of different GaN-based semiconductors. Specifically, in the semiconductor substrate 10 including the template substrate TS including the seed region S1 and the first semiconductor portion 8A located on the upper side of the template substrate TS and including a nitride semiconductor, the first semiconductor portion 8A may include the first raised portion R1 in contact with the seed region S1 and the first wing portion F1 facing the template substrate TS with the first void J1 therebetween, the first wing portion F1 may contain at least one of Al (aluminum) and In (indium), and the first raised portion R1 may be composed of a GaN-based semiconductor (such as GaN) different from the first wing portion F1.

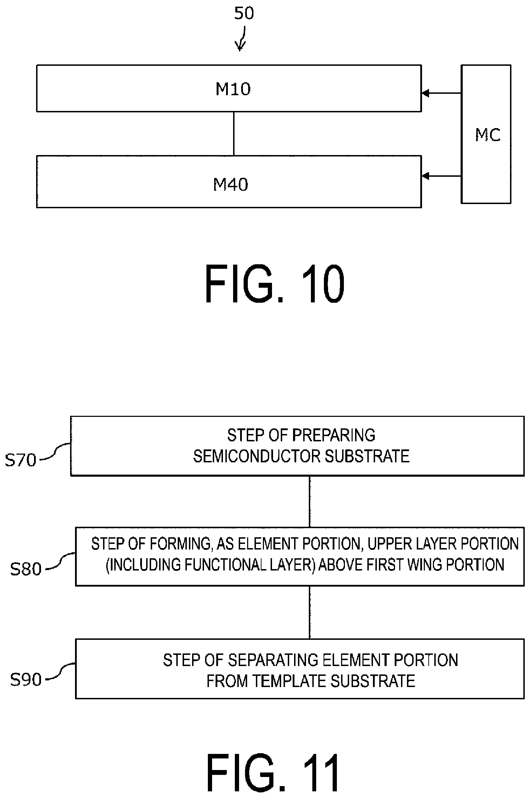

FIG. 10 is a block diagram illustrating a manufacturing device of the semiconductor substrate according to the present embodiment. A manufacturing device 50 for a semiconductor substrate includes a device M10 that performs step S10 of FIG. 7, a device M40 (wet etching device) that performs steps S20 and S30 of FIG. 7, and a control device MC that controls the devices M10 and M40.

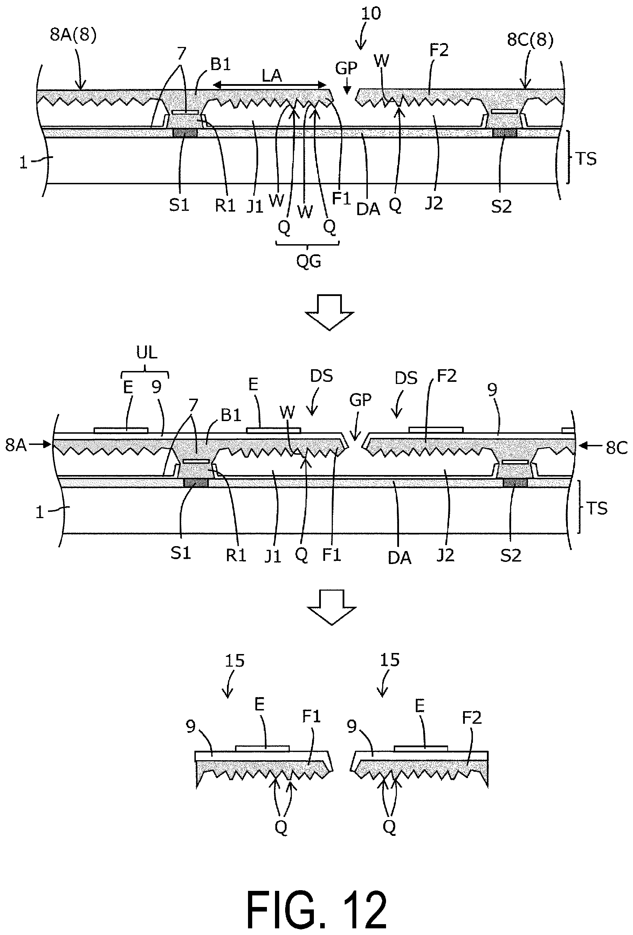

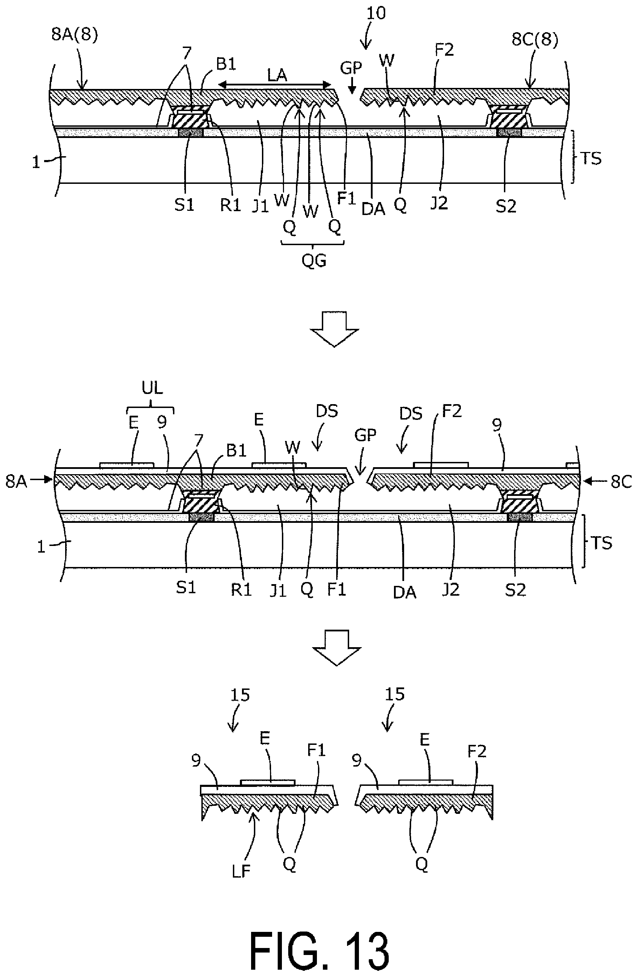

FIG. 11 is a flowchart illustrating a method for manufacturing the semiconductor device according to the present embodiment. FIGs. 12 and 13 are sectional views illustrating the method for manufacturing the semiconductor device according to the present embodiment. As illustrated in FIGs. 11 to 13, the method for manufacturing the semiconductor device according to the present embodiment includes step S70 of preparing the semiconductor substrate 10, step S80 of forming, as an element portion DS, the upper layer portion UL (including the functional layer 9) on the upper side of the first wing portion F1, and step S90 of separating, as a light-emitting element 15 (semiconductor device), the element portion DS from the template substrate TS. At step S90, the base end of the first wing portion F1 (the connecting portion with the first base portion B1) may be fractured by a downward external force. At step S90, the element portion DS may also be transferred from the template substrate TS to another substrate different from the template substrate TS (such as a transfer substrate, a supporting substrate, and a submount substrate).

At step S90, the base end of the first wing portion F1 may be cut by dry etching or wet etching. The cutting may be performed between the plurality of protrusions Q of the first wing portion F1. The protrusion Q located at the end of the cut surface may be higher than at least one of the other protrusions Q. The protrusion Q located at the cut surface (end surface) may have a higher defect density than at least one protrusion Q not located at the cut surface. Since the light-emitting element 15 includes the plurality of protrusions Q protruding downward, it provides excellent light extraction efficiency toward the back surface side (lower side).

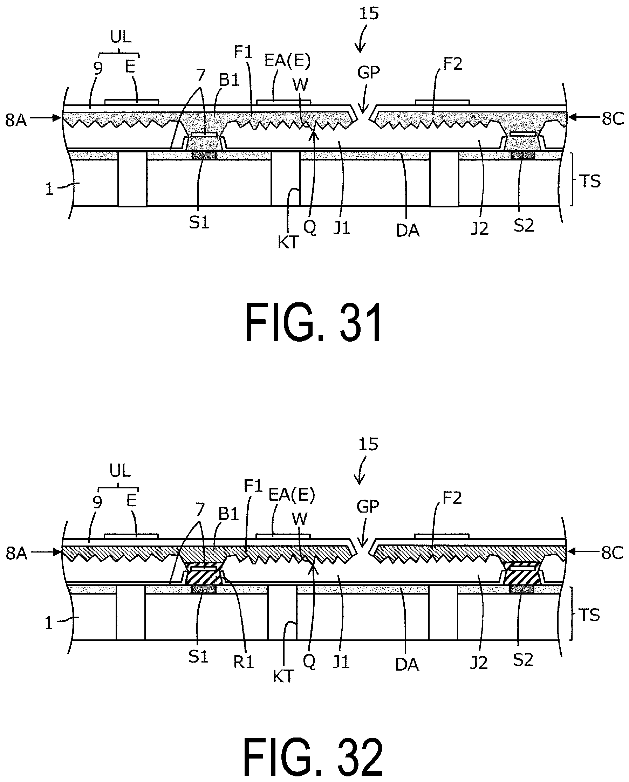

This method for manufacturing the semiconductor device may not include step S90 (the step of separating the element portion DS from the template substrate TS). For example, the method may include, after step S80, a step of forming an opening KT at a portion overlapping the first wing portion F1 in the template substrate TS as illustrated in FIGs. 31 and 32. In this manner, light can be extracted using the opening KT. Specifically, the light-emitting element 15 (semiconductor device) can be formed without performing the separation step S90.

The opening KT of the template substrate TS may be located at a portion overlapping the functional layer 9 (including the active layer), for example. The opening KT may be located at a portion overlapping a center portion of the first wing portion in the first direction X1, for example. In this manner, the light extraction efficiency to the back surface side (lower side) of the template substrate TS can be increased. As illustrated in FIGs. 31 and 32, the opening KT may overlap an anode EA in plan view. The template substrate TS may include a silicon substrate or a silicon carbide substrate.

The opening KT of the template substrate TS may or may not extend through the template substrate TS in the Z direction. For example, in the case where the opening KT does not extend through the template substrate TS in the Z direction, the template substrate TS may preferably be a light-transmissive member such as sapphire. An optical member such as a micro lens may be provided inside the opening KT. In this manner, the directivity of the light-emitting element 15 (semiconductor device) can be controlled. A phosphor member may be provided inside the opening KT. In this manner, the light-emission wavelength can be converted in accordance with the application of the light-emitting element 15 (semiconductor device).

### Example 1

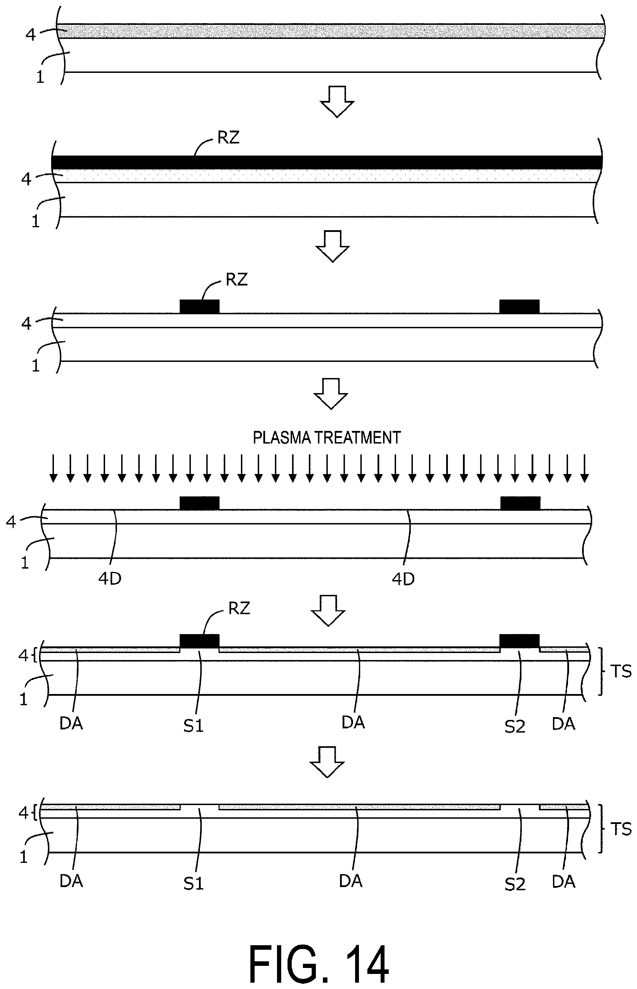

FIG. 14 is a sectional view illustrating a method for manufacturing a template substrate. As illustrated in FIG. 14, after a step of forming an underlying layer 4 containing an underlying material on the main substrate 1, a step of depositing a resist RZ onto the underlying layer 4, a step of patterning the resist RZ, a step of performing plasma treatment on the exposed underlying material, and a step of removing the resist RZ may be performed. The underlying layer 4 may be formed by a sputtering method. For example, in the plasma treatment, an exposed surface 4D of the underlying layer 4 is irradiated with argon plasma to modify the surface of the irradiated regions, thereby forming the growth suppression region DA. By introducing not only argon gas, but also oxygen gas, nitrogen gas, hydrogen gas or the like into the chamber, oxygen plasma, nitrogen plasma, hydrogen plasma, or a mixed plasma of these may be used in the plasma treatment, in addition to argon plasma. Thus, the growth suppression region DA may contain argon, oxygen, nitrogen, or the like as an impurity. In such a case, the underlying material may be aluminum nitride and the growth suppression region DA may be aluminum oxynitride. The underlying material may be aluminum scandium nitride (AlScN) and the growth suppression region DA may be aluminum scandium oxynitride (AlScON).

The underlying layer 4 can be optimized according to the material of the main substrate 1. For example, when the main substrate 1 is a silicon substrate, aluminum nitride can be used for the underlying layer 4; when the main substrate 1 is a sapphire substrate or a silicon carbide substrate, aluminum nitride, aluminum oxynitride, or gallium nitride can be used for the underlying layer 4.

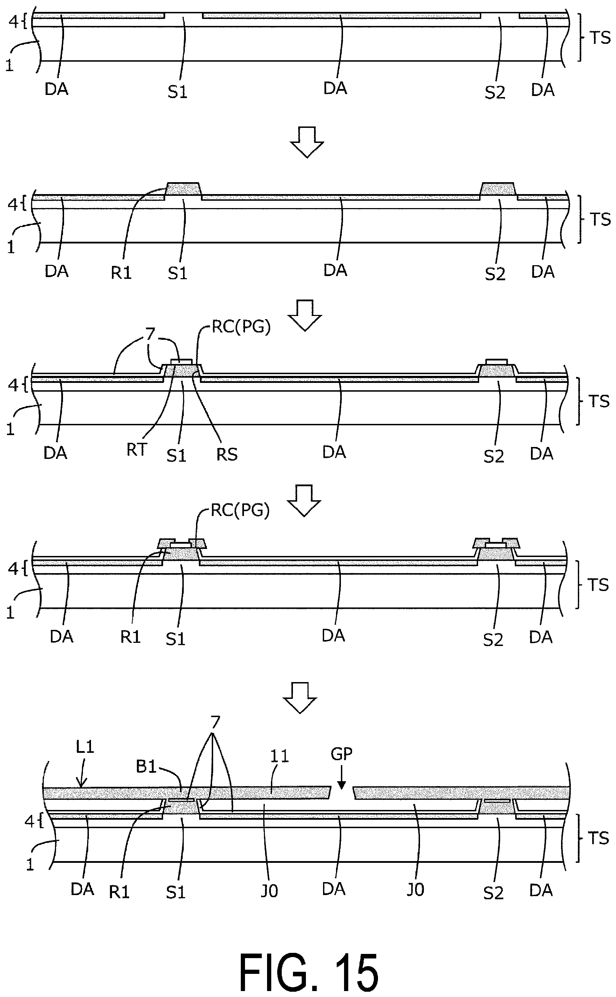

FIG. 15 is a sectional view illustrating a method for depositing a GaN crystal portion of an initial wing portion by ELO. In FIG. 10, the method includes a step of preparing the template substrate TS including the seed regions S1 and S2 and the growth suppression region DA, a step of vertically growing the first raised portion R1 from the seed region S1, a step of forming the growth suppression film 7 in contact with the first raised portion R1, and a step of forming the first base portion B1 located on the upper side of the first raised portion R1, and the GaN crystal portion 11 that is connected to the first base portion B1, separated from the growth suppression region DA and located on the upper side of the void J0.

As illustrated in FIG. 15, the first base portion B1 and the GaN crystal portion 11 may be formed with a corner portion RC, where a top surface RT and a side surface RS of the first raised portion R1 intersect, as a growth starting point PG. Although the corner portion RC may be used as the growth starting point PG in this manner, this is not limitative. A defect portion (e.g., a micro opening) may be formed in the growth suppression film 7 on the upper side of the first raised portion R1, and the defect portion of the growth suppression film 7 may be used as the growth starting point of the first base portion B1 and the GaN crystal portion 11.

The first raised portion R1, the growth suppression film 7, the first base portion B1 and the GaN crystal portion 11 may be continuously formed using a MOCVD device. The first raised portion R1 may contain a GaN-based semiconductor and the growth suppression film 7 may be silicon nitride, such that the first raised portion R1 is formed by supplying a gallium-source material (an organic material such as trimethylgallium (TMG) and triethyl gallium (TEG)) and a nitrogen-source material (ammonia gas (NH₃)), and that the growth suppression film 7 (in this case, a silicon nitride film) is formed by supplying a silicon-based material (such as SiH₄) and ammonia gas (NH₃) while stopping the supply of gallium-source material and maintaining the supply of nitrogen-source material. Note that oxygen or carbon may be added, and the growth suppression film 7 may be formed using a different material. Thereafter, the first base portion B1 and the GaN crystal portion 11 may be formed by supplying a gallium-source material while stopping the supply of the silicon-based material and maintaining the supply of nitrogen-source material. The supply of a small amount of silicon-based material may be continued at the doping level.

By forming the growth suppression film 7 in this manner, deposition can be continuously performed while forming the void J0 under the GaN crystal portion 11 without unloading it from the MOCVD device, thereby reducing the manufacturing time and cost. By forming the void J0 to form the GaN crystal portion 11 not in contact with the underlying layer 4 (the growth suppression region DA), stress and the like from the main substrate 1 and the underlying layer 4 can be effectively alleviated.

Here, the growth of two GaN crystal layers that grow in opposite directions on the upper side of the growth suppression region DA is stopped before they join each other. As a result, the gap GP can be formed, and this gap GP allows the etching liquid YE to more easily reach the back surface, thus enabling constant circulation of fresh etching liquid YE into the void on the upper side of the growth suppression region DA through stirring. In this manner, variations in the shape of the protrusions Q on the rear surface of the first wing portion F1 can be suppressed. The width of the gap GP may be 0.5 [µm] or more, or 1.0 [µm] or more.

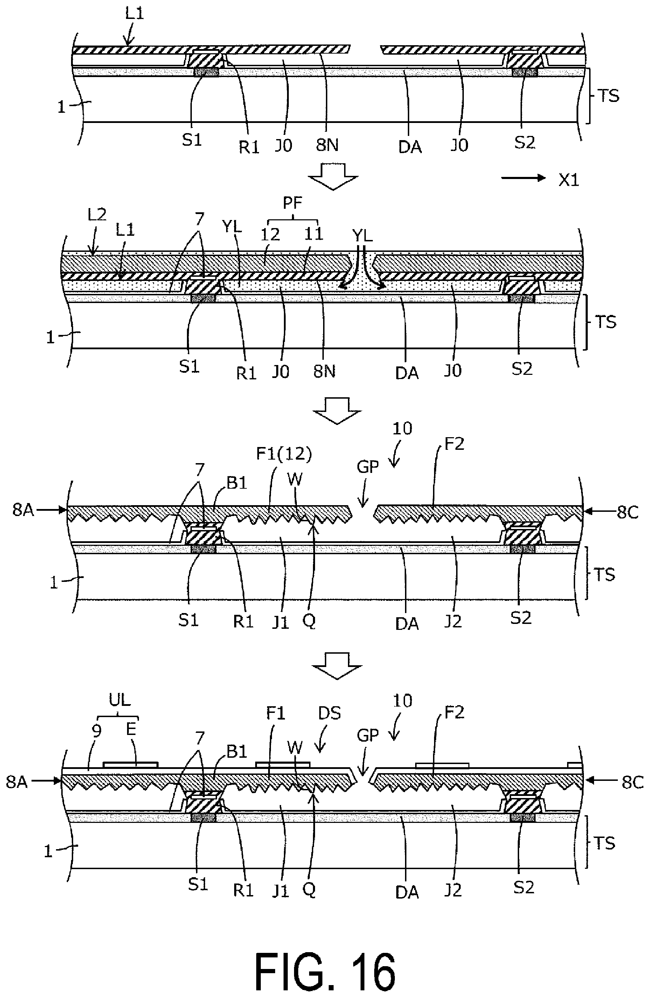

FIG. 16 is a sectional view illustrating a method for manufacturing a semiconductor substrate according to Example 1. As illustrated in FIG. 16, the GaN mixed crystal portion 12 is grown on the GaN crystal portion 11 so as to form the initial wing portion PF, and the initial wing portion PF is etched from the back surface (nitrogen-polar surface 8M) with etching liquid YL introduced in the void J0 so as to remove the GaN crystal portion 11 and etch the back surface (nitrogen-polar surface) of the GaN mixed crystal portion 12, thereby forming the first wing portion F1. The upper layer portion UL is formed on the upper side of the first wing portion F1, and thus the element portion DS is configured.

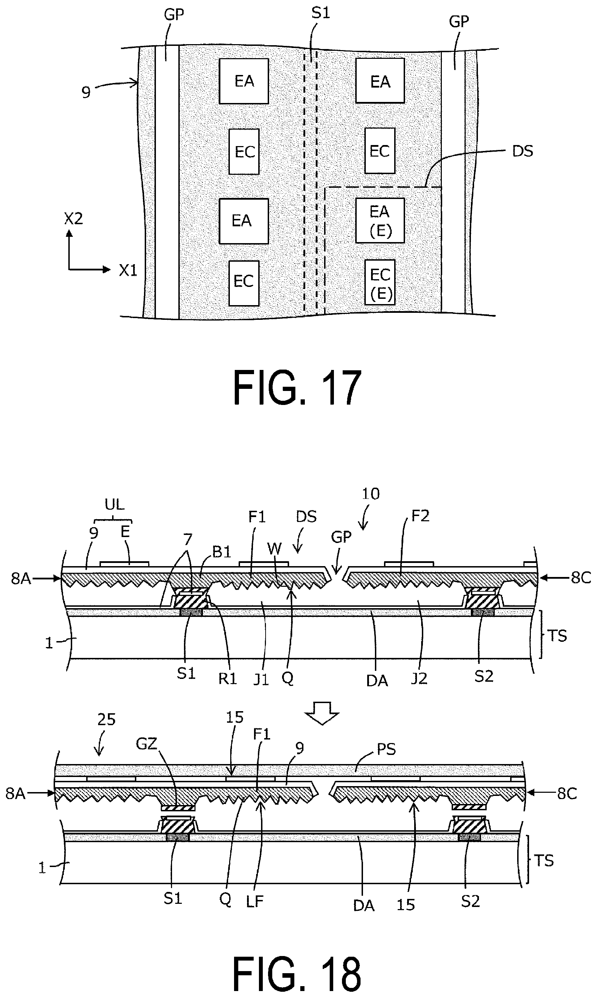

FIG. 17 is a plan view illustrating the semiconductor substrate according to Example 1. As illustrated in FIG. 17, the anode EA and a cathode EC may be disposed side by side in the second direction X2 (e.g., the m-axis direction of the GaN mixed crystal portion 12) on the functional layer 9, such that the element portion DS is formed to include the anode EA and the cathode EC.

FIG. 18 is a sectional view illustrating a method for manufacturing a semiconductor device according to Example 1. In Example 1 (FIGs. 16 to 18), the method is performed in the following order: ELO deposition of the GaN crystal layer L1 and formation of the growth suppression film 7 using the MOCVD, deposition of the GaN mixed crystal layer L2 using the MOCVD, unloading of the template substrate TS where an initial wing layer PF (11 and 12) is formed from the MOCVD, removal (wet etching) of the GaN crystal portion 11 of the initial wing layer PF, wet etching of the back surface (nitrogen-polar surface) of the GaN mixed crystal portion 12, introduction of the semiconductor substrate 10 including the first wing portion F1 (the GaN mixed crystal portion 12) into the MOCVD, deposition of the functional layer 9 (including the active layer) on the upper side of the first wing portion F1 (the GaN mixed crystal portion 12), unloading of the semiconductor substrate 10 including the functional layer 9 from the MOCVD, formation of the electrode E and the like on the upper side of the functional layer 9 (including the active layer) (formation of the element portion DS), and separation of the element portion DS from the template substrate TS (formation of the light-emitting element 15 through singularization). As illustrated in FIG. 18, a light-emitting element (semiconductor device) 15 or a semiconductor device 25 including the supporting substrate PS and the light-emitting element 15 may be obtained by separating the element portion DS from the template substrate TS by dividing the first semiconductor portion 8A into upper and lower portions at the adjoining portion of the growth suppression film 7 in the state where the first semiconductor portion 8A is held on a supporting substrate PS. The first semiconductor portion 8A may be divided by cleavage. A portion GZ of the GaN crystal layer L1 may remain on the lower side of the light-emitting element 15.

The light-emitting element 15 (semiconductor device) may include a nitride semiconductor base member (first wing portion) F1 including a light extraction surface LF, and the functional layer 9 including an active layer, and the nitride semiconductor base member F1 may include, at the light extraction surface LF, the plurality of protrusions Q, each of which has the inclined surface W inclined with respect to the thickness direction of the nitride semiconductor base member F1, and the nitride semiconductor base member F1 may have a threading dislocation density of 5 × 10⁶ dislocations/cm² or less. The nitride semiconductor base member (F1) needs only to include at least one of the GaN crystal portion 11 and the GaN mixed crystal portion 12, and the light extraction surface LF may be the GaN crystal portion 11 (GaN), or the GaN mixed crystal portion 12 (such as AlGaN, InGaN, and AlInGaN). At the light extraction surface LF, the -c-plane ((000-1) plane) as a nitrogen-polar surface may be exposed between adjacent protrusions Q. The protrusion group including the plurality of protrusions Q may be formed over the entire surface of the light extraction surface LF of the nitride semiconductor base member F1.

The nitride semiconductor base member (F1) may be a nitride semiconductor crystal having a thickness of 8.0 [µm] or less, the light extraction surface LF may include the plurality of pyramidal protrusions Q having a height of 100 [nm] or more, and the light extraction surface LF may include the -c-plane of the nitride semiconductor. The nitride semiconductor base member (F1) may have a threading dislocation density of 5 × 10⁶ dislocations/cm² or less.

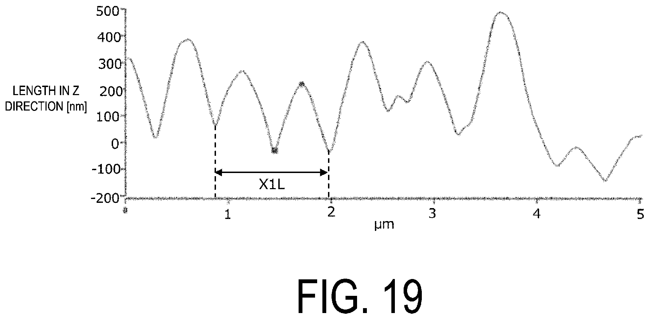

FIG. 19 shows a measurement result obtained using an atomic force microscope (AFM: JupiterX manufactured by Oxford Instruments), for the plurality of protrusions Q of the nitride semiconductor base member (F1) produced by the above-mentioned manufacturing method. In FIG. 19, the abscissa indicates the length (µm) in the lateral direction, and the ordinate indicates the length (nm) in the thickness direction (the Z direction). According to FIG. 19, one of the plurality of protrusions Q has two adjacent local minima as its base and a local maximum located between the two adjacent local minima as its apex. There are two protrusions Q within a range X1L in FIG. 19. A maximum height Rz may be used as the roughness of the plurality of protrusions Q. According to this measurement result, the Rz of the plurality of protrusions Q of the nitride semiconductor (F1) was from 200 nm to 300 nm.

In FIGs. 16 and 17, since the functional layer 9 can be formed on the upper side of the GaN mixed crystal portion 12 not in contact with the template substrate TS, a significant stress-relief effect can be achieved for the functional layer 9. Before the functional layer 9 is formed, the top surface (gallium-polar surface) of the initial wing layer PF is finely etched, and thus a clean and flat top surface of the first wing portion F1 (surface) is obtained. By forming the functional layer 9 on the upper side of this first wing portion F1, a high-quality functional layer 9 can be obtained. The height of the void J0 (distance between the initial wing layer PF and the growth suppression region DA) may be 10 nm or more to allow the etching liquid YE to reach deep inside, and when it is 100 nm or more, the effect of suppressing uneven etching on the back surface becomes more pronounced.

In Example 1, the thickness of the first wing portion F1 may be from 0.1 [µm] to 5.0 [µm] or from 0.2 [µm] to 3 [µm], and the width of the first wing portion F1 in the first direction X1 may be from 20 [µm] to 200 [µm]. The first wing portion F1 may have a ratio of width to thickness of 2.0 or more, 3.0 or more, 5.0 or more, 10.0 or more, or 20 or more. The void J1 may have a ratio of width to thickness (height) in the first direction X1 of 2.0 or more, 3.0 or more, 5.0 or more, 10.0 or more, or 20 or more.

The GaN mixed crystal portion 12 may be, for example, a ternary or quaternary mixed crystal of AlxGayInzN (0 ≤ x ≤ 1; 0 ≤ y ≤ 1; 0 ≤ z ≤ 1; x + y + z = 1). The GaN mixed crystal portion 12 may contain additives such as Sc, and may be doped with n-type dopants such as Si or Ge, or p-type dopants such as Mg. The dopants may also be unintentionally doped.

When manufacturing a short-wavelength light-emitting element 15, the first wing portion F1 may be provided as an AlGaN base member with an Al composition of 10% by forming the GaN mixed crystal portion 12 as Al_{0.1}Ga_{0.9}N and removing the GaN crystal portion 11. In this case, the emission wavelength of the light-emitting element 15 may be 380 nm or less.

When manufacturing a medium-wavelength light-emitting element 15, the first wing portion F1 may be provided as an InGaN base member with an In composition of 15% by forming the GaN mixed crystal portion 12 as In_{0.15}Ga_{0.85}N and removing the GaN crystal portion 11. In this case, the light-emission wavelength of the light-emitting element 15 may be 500 nm or more.

In Example 1, at the time when the GaN mixed crystal portion 12 is formed, the template substrate TS with the initial wing portion PF formed is unloaded from the MOCVD device, and the initial wing portion PF is wet-etched. Since the initial wing portions PF adjacent to each other on the upper side of the growth suppression region DA are separated from each other, and the initial wing portion PF is separated from the growth suppression region DA, the etching liquid easily flows around to the back surface (the nitrogen-polar surface 8N) of the initial wing portion PF, and thus the etching rapidly proceeds.

As the etching liquid, an alkaline solution such as potassium hydroxide (KOH) or sodium hydroxide (NaOH) may be used. Etching is possible even at room temperature; however, heating to approximately 80°C increases the etching rate. The etching rate may be controlled by adjusting the concentration and temperature of the etching liquid.

By using a template substrate TS having a c-plane or a surface orientation with an off-angle from the c-plane, the back surface (bottom surface) of the initial wing portion PF exposes a nitrogen-polar surface, while the opposite front surface (top surface) of the initial wing portion PF has a Ga-, Al-, or In-polar surface. Since the nitrogen-polar surface has a significantly higher etching rate than the Ga-, Al-, or In-polar surface, the front surface (top surface) of the initial wing portion PF (i.e., the top surface of the GaN mixed crystal portion 12) is scarcely etched, and only the back surface (bottom surface) having nitrogen polarity is preferentially etched. As a result, the GaN crystal portion 11 of the initial wing portion PF can be efficiently removed, and the top surface of the GaN mixed crystal portion 12 is slightly etched, thereby improving the surface morphology. The first raised portion R1 of the GaN crystal layer L1 is scarcely etched, since the exposed side surface is not a nitrogen-polar surface.

On the back surface (bottom surface) of the first wing portion F1 obtained by etching the initial wing portion PF, a large number of protrusions Q with a pyramidal shape (or quadrangular pyramidal shape), surrounded by {10-1-1} planes of the GaN mixed crystal, appear (as illustrated in FIG. 4), for example. The back surface of the first wing portion F1 serves as the light extraction surface in the configuration of the device (light-emitting element), and the large number of protrusions Q increase the light extraction efficiency. In Example 1, in which the GaN crystal portion 11 is removed by etching, the first wing portion F1 can be made thin, thereby reducing side emission (which causes optical interference between elements) in the device (light-emitting element) configuration.

In Example 1, the GaN crystal portion 11 of the initial wing portion PF is completely removed, but a part of the GaN crystal portion 11 of the initial wing portion PF may be left to increase the strength of the first wing portion F1. When forming the functional layer 9 that emits light with a wavelength shorter than 380 nm on the upper side of the first wing F1, it is preferable to remove the GaN crystal portion 11, since it may absorb light emitted from the functional layer 9 if it remains.

When forming the functional layer 9 that emits light with a wavelength of 365 nm, the following layers may be formed on the upper side of the GaN mixed crystal portion 12 in the following order: a regrowth layer (Al_{0.1}Ga_{0.9}N with a thickness of 0.05 µm), five pairs of multiple quantum wells (a barrier layer: Al_{0.07}Ga_{0.93}N with a thickness of 15 nm; a well layer: AlInGaN with a thickness of 3 nm), a carrier blocking layer (Al_{0.25}Ga_{0.75}N with a thickness of 20 nm), and a p-type layer (a contact layer: Al_{0.07}Ga_{0.93}N with a thickness of 20 nm; a heavily doped layer: GaN with a thickness of 1.5 µm).

When forming the functional layer 9 that emits light with a wavelength longer than 500 nm, the following layers may be formed on the upper side of the GaN mixed crystal portion 12 in the following order: a regrowth layer (GaN with a thickness of 0.1 µm), three pairs of multiple quantum wells (a barrier layer: Al_{0.07}Ga_{0.93}N with a thickness of 15 nm; a well layer: In_{0.33}Ga_{0.67}N with a thickness of 3 nm), a carrier blocking layer (Al_{0.1}Ga_{0.9}N with a thickness of 20 nm), and a p-type layer (a contact layer: GaN with a thickness of 20 nm; a heavily doped layer: GaN with a thickness of 1.5 µm).

The electrode E (anode and cathode) is formed in a predetermined region on the upper side of the functional layer 9 using a sputtering device or an EB evaporation device.

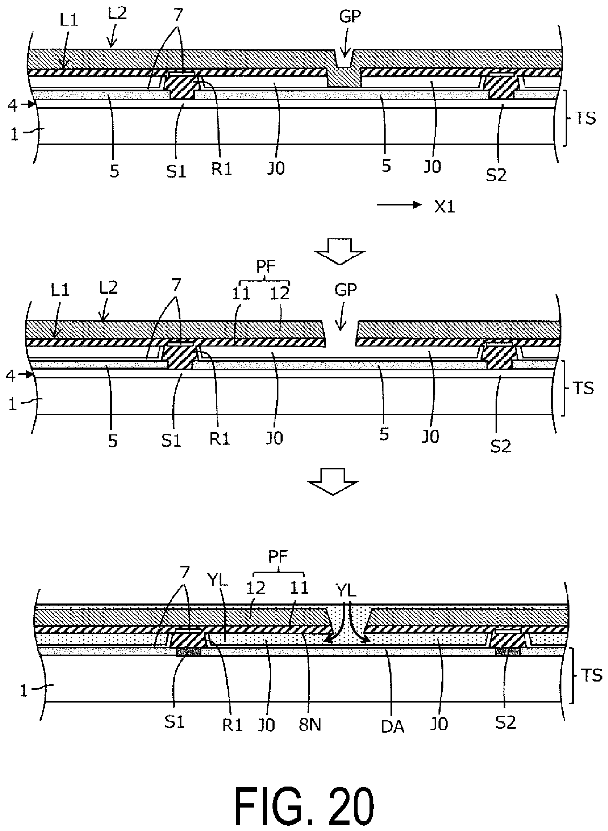

FIG. 20 is a sectional view illustrating the method for manufacturing the semiconductor substrate according to Example 1. When the GaN mixed crystal layer L2 is formed to fill the gap GP between the GaN crystal portions 11 and the space below it, the filled portion may be removed by dry etching or the like to separate the GaN mixed crystal layer L2 in the first direction X1 (the GaN mixed crystal portion 12 and the gap GP may be formed), and thereafter etchant may be introduced from the gap GP to wet-etch the back surface (nitrogen-polar surface) of the GaN mixed crystal portion 12 and the GaN crystal portion 11 as illustrated in FIG. 20.

### Example 2

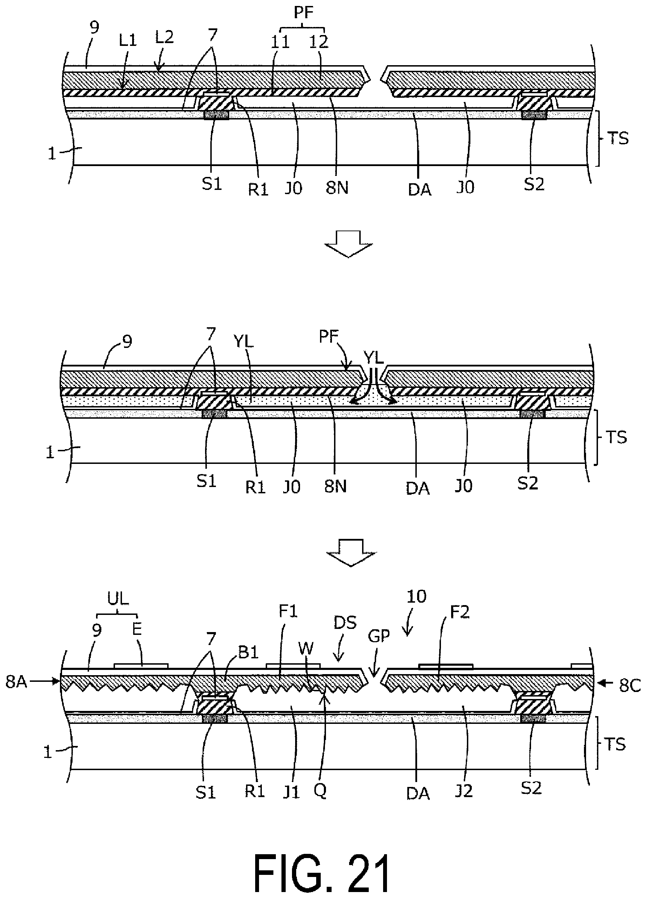

FIG. 21 is a sectional view illustrating a method for manufacturing a semiconductor substrate according to Example 2. As illustrated in FIG. 21, after the GaN crystal layer L1, the GaN mixed crystal layer L2 and the functional layer 9 (including the active layer) are continuously deposited, the GaN crystal portion 11 of the initial wing layer PF may be removed (wet-etched). Thereafter, formation of the electrode E and the like on the upper side of the functional layer 9 (including the active layer) (formation of the element portion DS), and separation of the element portion DS from the template substrate TS (formation of the light-emitting element 15 through singularization) are performed. In Example 2, since the template substrate TS is not unloaded from the MOCVD during deposition of the nitride semiconductor, the productivity (throughput) is enhanced.

### Example 3

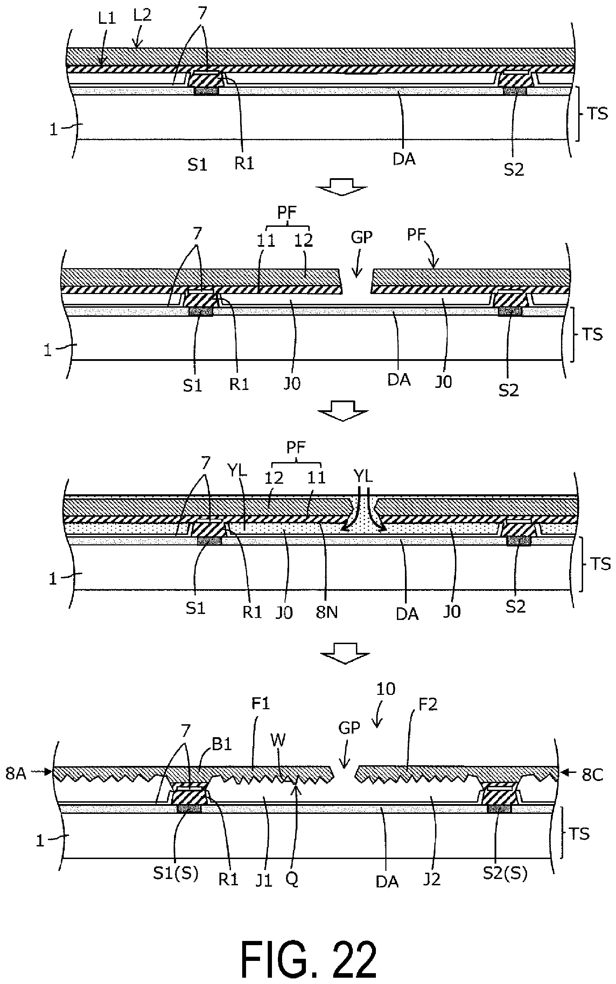

FIG. 22 is a sectional view illustrating a method for manufacturing a semiconductor substrate according to Example 3. As illustrated in FIG. 22, when the GaN crystal layer L1 is deposited by ELO, the GaN crystal layer L1 and the GaN mixed crystal layer L2 may be formed in a planar shape by joining the GaN crystals that grow in opposite directions on the upper side of the growth suppression region DA. In this case, the gap GP between the initial wing portions PF can be formed through dry etching or the like of the GaN crystal layer L1 and the GaN mixed crystal layer L2 having a planar shape, and the etching liquid YL can be introduced from the gap GP.

### Example 4

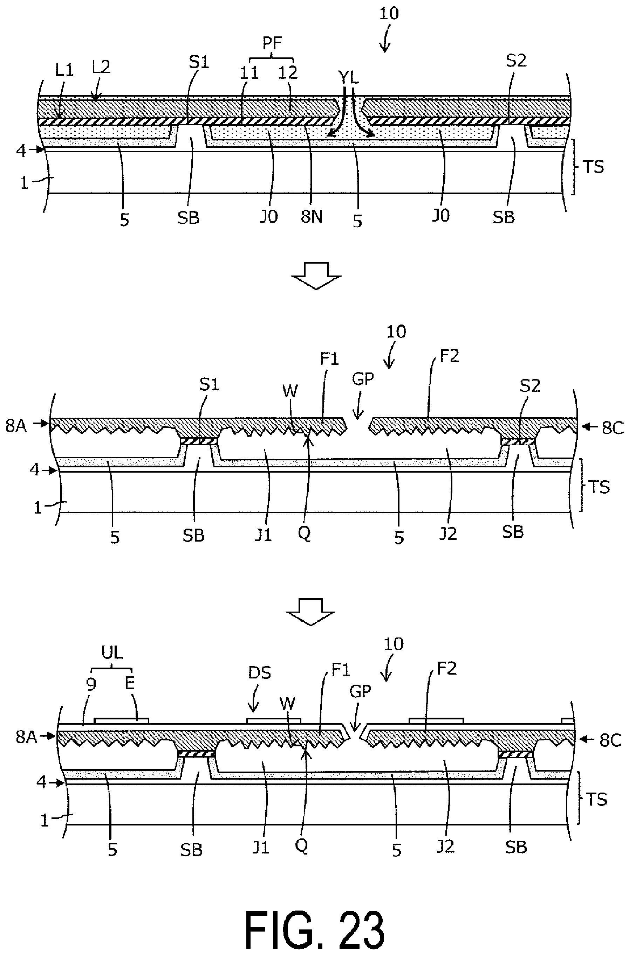

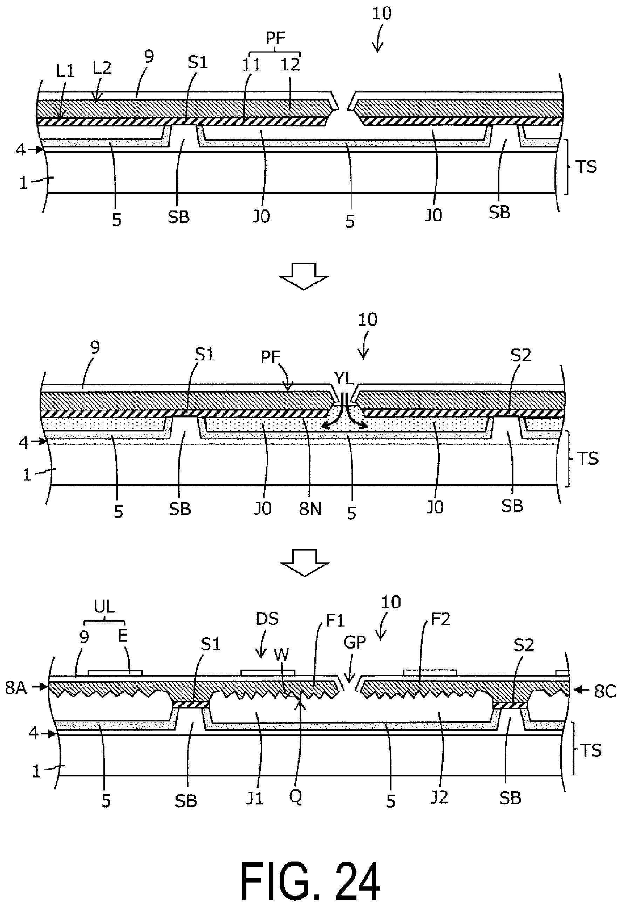

FIGs. 23 and 24 are sectional views illustrating a method for manufacturing a semiconductor substrate according to Example 4. As illustrated in FIG. 23, the void J0 may be formed between the template substrate TS and the initial wing portion PF by forming the initial wing portion PF (the GaN crystal portion 11 and the GaN mixed crystal portion 12) on the upper side of the growth suppression region DA from the seed regions S1 and S2 located at the top surface of a seed portion SB having a protruding shape (ridge shape), and the first wing portion F1 may be formed through etching removal from the back surface of the GaN crystal portion 11 using the etching liquid YL introduced in the void J0. In Example 4, the thickness of the void J0 can be easily designed by adjusting the height of the seed portion SB. By increasing the thickness of the void J0, etching liquid can more easily flow around to the back side, thereby enhancing the efficiency of etching. As illustrated in FIG. 24, the etching removal of the GaN crystal portion 11 of the initial wing layer PF may be performed after the GaN crystal layer L1, the GaN mixed crystal layer L2 and the functional layer 9 (including the active layer) are continuously deposited.

### Example 5

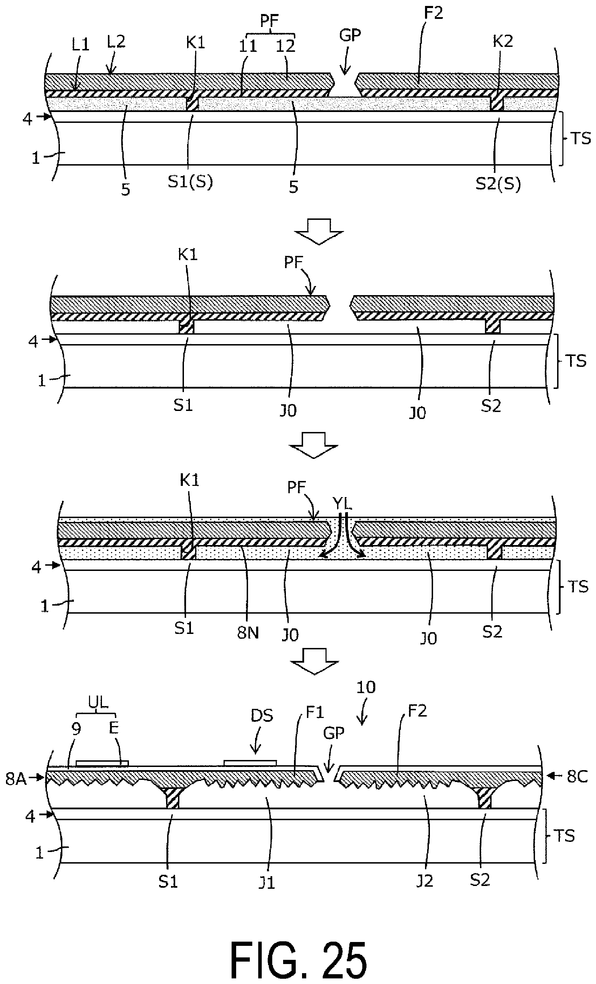

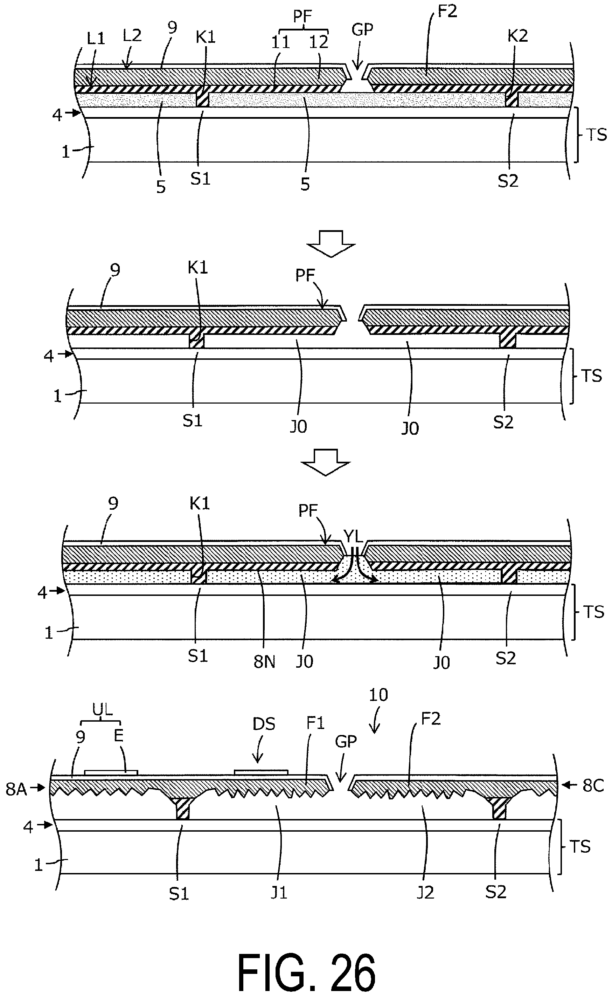

FIGs. 25 and 26 are sectional views illustrating a method for manufacturing a semiconductor substrate according to Example 5. As illustrated in FIG. 25, the GaN mixed crystal layer L2 may be formed on the upper side of the GaN crystal layer L1 formed by ELO in contact with a mask portion 5 (growth suppression region) from a mask opening portion K1 functioning as a seed region S, and thereafter the void J0 may be formed between the template substrate TS and the initial wing portion PF by removing the mask portion 5 so as to etch the GaN crystal portion 11 using the etching liquid YL introduced in the void J0, thereby forming the first wing portion F1. As illustrated in FIG. 26, the etching removal of the GaN crystal portion 11 of the initial wing layer PF may be performed after the GaN crystal layer L1, the GaN mixed crystal layer L2 and the functional layer 9 (including the active layer) are continuously deposited.

### Example 6

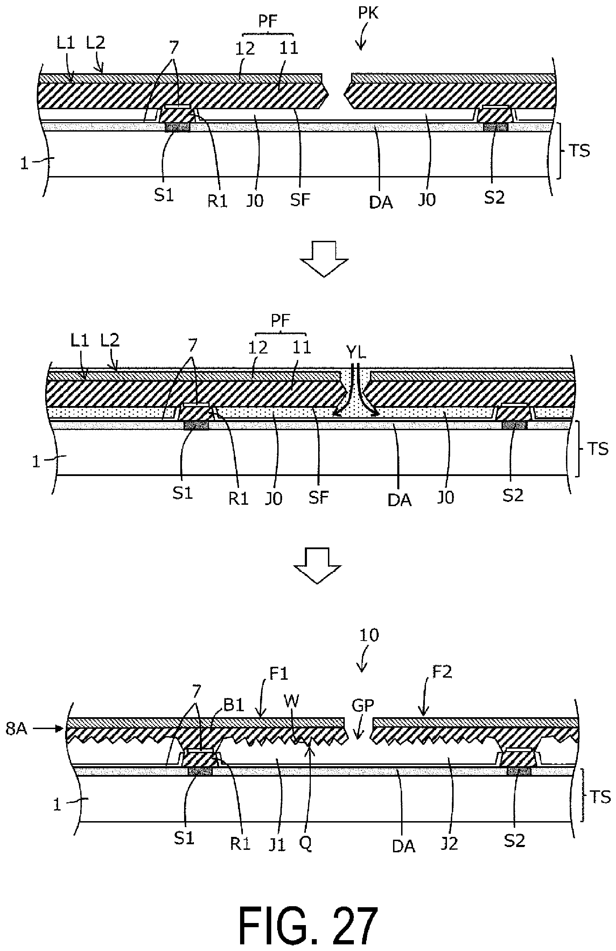

FIG. 27 is a sectional view illustrating a method for manufacturing a semiconductor substrate according to Example 6. In FIG. 23, the GaN crystal portion 11 below the GaN mixed crystal portion 12 is entirely removed by etching, but this is not limitative. As illustrated in FIG. 27, the first wing portion F1 may be formed by etching the initial wing portion PF such that a part of the GaN crystal portion 11 is left below the GaN mixed crystal portion 12.

### Example 7

FIG. 28 is a schematic view illustrating a configuration of an electronic device according to Example 7. An electronic device 55 of FIG. 28 includes a light-emitting element (semiconductor device) 15, a driving substrate 23 on which the light-emitting element 15 is mounted, and a control circuit 27 that controls the driving substrate 23. The driving substrate 23 may include a CMOS. Examples of the electronic device 55 include a light-emitting device, a display device, a laser emitting device (including a Fabry-Perot type and a surface emitting type), a measurement device, an illumination device, a communication device, an information processing device, and a power control device.

### Supplementary Note

The foregoing disclosure has been presented for purposes of illustration and description, and not limitation. It is noted that many variations will be apparent to those skilled in the art based on these illustrations and descriptions, and these variations are included in the embodiments.

### REFERENCE SIGNS

- 1: Main substrate
- 4: Underlying layer
- 7: Growth suppression film
- 8A: First semiconductor portion
- 8C: Second semiconductor portion
- 10: Semiconductor substrate
- 11: GaN crystal portion
- 12: GaN mixed crystal portion
- 15 25: Light-emitting element (semiconductor device)
- L1: GaN crystal layer
- L2: GaN mixed crystal layer
- R1: First raised portion
- B1: First base portion
- F1: First wing portion
- F2: Second wing portion
- J0, J1, J2: Void
- S1: Seed portion
- DA: Growth suppression region
- TS: Template substrate

## Claims

1. A semiconductor substrate comprising:
a template substrate; and
a first semiconductor portion located on an upper side of the template substrate, and including a nitride semiconductor, wherein
the first semiconductor portion includes a first wing portion separated from the template substrate,
the first wing portion includes a plurality of protrusions protruding downward, and
at least one of the plurality of protrusions has a tapered shape with an inclined surface inclined with respect to a thickness direction of the template substrate.

2. The semiconductor substrate according to claim 1, wherein a mixed crystal of a GaN-based semiconductor containing at least one of aluminum and indium is exposed on a lower side of the first wing portion.

3. The semiconductor substrate according to claim 1 or 2, wherein
the first semiconductor portion includes a first raised portion located on an upper side of the template substrate, and a first base portion connected to the first raised portion and the first wing portion, and
the first raised portion and the first wing portion are formed of different GaN-based semiconductors.

4. The semiconductor substrate according to any one of claims 1 to 3, wherein the protrusion has a pyramidal shape.

5. The semiconductor substrate according to any one of claims 1 to 4, wherein a roughness of a top surface of the first wing portion is smaller than a roughness of a bottom surface of the first wing portion.

6. The semiconductor substrate according to any one of claims 1 to 5, wherein a roughness of a side surface of the first wing portion is smaller than a roughness of the bottom surface of the first wing portion.

7. The semiconductor substrate according to claim 2, wherein the first wing portion is an AlGaN base member, an AlInGaN base member, or an InGaN base member.

8. The semiconductor substrate according to claim 2, wherein a nitrogen-polar surface of the mixed crystal is exposed on a lower side of the first wing portion.

9. The semiconductor substrate according to any one of claims 1 to 8, further comprising an upper layer portion located on an upper side of the first wing portion, wherein
the upper layer portion includes an active layer.

10. The semiconductor substrate according to any one of claims 1 to 9, wherein
the first semiconductor portion includes a first raised portion located on an upper side of the template substrate, and a first base portion connected to the first raised portion and the first wing portion,
the first wing portion includes a low-defect portion having a lower defect density than the first base portion, and
a protrusion group including the plurality of protrusions is located over an entire region on a lower side of the low-defect portion.

11. The semiconductor substrate according to any one of claims 1 to 10, wherein the first wing portion has a thickness of 8.0 [µm] or less.

12. The semiconductor substrate according to any one of claims 1 to 11, wherein the protrusion has a height of 100 [nm] or more.

13. The semiconductor substrate according to any one of claims 1 to 12, wherein
a void is located between the first wing portion and the template substrate, and
a ratio of a width to a height of the void is 5.0 or more.

14. The semiconductor substrate according to any one of claims 1 to 13, further comprising a second semiconductor portion located on an upper side of the template substrate, and including a nitride semiconductor, wherein
the second semiconductor portion includes a second wing portion separated from the template substrate, and
the second wing portion includes a plurality of protrusions protruding downward.

15. The semiconductor substrate according to claim 14, wherein the first wing portion is adjacent to the second wing portion through a gap.

16. The semiconductor substrate according to claim 14, wherein a top surface of the template substrate includes a growth suppression region, and two seed regions adjacent to each other with the growth suppression region between the two seed regions.

17. The semiconductor substrate according to claim 16, wherein the first wing portion and the second wing portion are located on an upper side of the growth suppression region.

18. The semiconductor substrate according to claim 16, wherein the first semiconductor portion includes a first base portion located on an upper side of one of the two seed regions.

19. The semiconductor substrate according to claim 18, wherein
the first semiconductor portion includes a first raised portion in contact with one of the two seed regions, and
the semiconductor substrate comprises a growth suppression film located between the first raised portion and the first base portion.

20. The semiconductor substrate according to claim 17, wherein a material of the growth suppression region is a material obtained by modifying a material of the two seed regions.

21. The semiconductor substrate according to claim 21, wherein the material of the two seed regions is an aluminum nitride.

22. The semiconductor substrate according to any one of claims 1 to 21, wherein
a +c-plane of the nitride semiconductor is exposed at the top surface of the first wing portion, and
a -c-plane of the nitride semiconductor is exposed at the bottom surface of the first wing portion.

23. The semiconductor substrate according to claim 3, wherein a roughness of a side surface of the first raised portion is smaller than a roughness of a bottom surface of the first wing portion.

24. The semiconductor substrate according to claim 22, wherein
the +c-plane is a gallium-polar surface, an aluminum-polar surface, or an indium-polar surface, and
the -c-plane is a nitrogen-polar surface.

25. The semiconductor substrate according to any one of claims 1 to 24, wherein
a void is located between the first wing portion and the template substrate, and
a ratio of a thickness of the first wing portion to a thickness of the void is smaller than 2.0.

26. The semiconductor substrate according to claim 3, wherein
the first raised portion is a GaN crystal, and
the first wing portion is a GaN mixed crystal containing at least one of Al and In.

27. A method for manufacturing a semiconductor substrate, comprising:
forming an initial wing portion located on an upper side of a template substrate without making contact with the template substrate, the initial wing portion including a nitride semiconductor and a nitrogen-polar surface exposed on a lower side;
introducing etching liquid into a gap between the nitrogen-polar surface of the initial wing portion and the template substrate; and
forming a first wing portion including a plurality of protrusions protruding downward by advancing etching of the initial wing portion mainly from the nitrogen-polar surface.

28. The method for manufacturing the semiconductor substrate according to claim 27,
wherein
the initial wing portion includes a GaN crystal portion where the nitrogen-polar surface is exposed, and a GaN mixed crystal portion containing at least one of aluminum and indium, and
the first wing portion including at least a part of the GaN mixed crystal portion is formed by removing the GaN crystal portion through the etching.

29. The method for manufacturing the semiconductor substrate according to claim 27 or 28, wherein
the template substrate includes a mask portion containing silicon, and
the method comprises forming the gap by removing the mask portion.

30. A method for manufacturing a semiconductor device, comprising:
preparing the semiconductor substrate according to claim 1;
forming a functional layer on an upper side of the first wing portion; and
separating the first wing portion and the functional layer from the template substrate.

31. The method for manufacturing the semiconductor device according to claim 30,
wherein
the first wing portion includes a low-defect portion having a lower defect density than the first base portion, and
a protrusion group including the plurality of protrusions is located over an entire region on a lower side of the low-defect portion.

32. A method for manufacturing a semiconductor device, comprising:
preparing the semiconductor substrate according to claim 1; and
forming a functional layer on an upper side of the first wing portion, wherein
the template substrate includes a light transmitter that transmits light in a normal direction of the template substrate, and
the light transmitter and a portion including the plurality of protrusions in the first wing portion overlap each other in the normal direction.

33. A method for manufacturing a semiconductor device, comprising:
preparing the semiconductor substrate according to claim 1;
forming a functional layer on an upper side of the first wing portion; and
separating an element including the first wing portion and the functional layer from the template substrate.

34. The method for manufacturing the semiconductor device according to claim 33,
wherein the element is transferred from the template substrate to a transfer substrate.

35. The method for manufacturing the semiconductor device according to claim 33,
wherein a light-emitting element is obtained by separating the element from the template substrate.

36. A semiconductor device comprising:
a nitride semiconductor base member including a light extraction surface; and
a functional layer including an active layer, wherein
the nitride semiconductor base member includes a plurality of protrusions at the light extraction surface,
at least one of the plurality of protrusions has a tapered shape with an inclined surface inclined with respect to a thickness direction of the nitride semiconductor base member, and
the nitride semiconductor base member has a threading dislocation density of 5 × 10⁶ dislocations/cm² or less.

37. A light-emitting element, comprising:
a nitride semiconductor base member including a light extraction surface; and
a functional layer including an active layer, wherein
the nitride semiconductor base member is a crystal of a nitride semiconductor having a thickness of 8.0 [µm] or less,
the light extraction surface includes a plurality of protrusions having a pyramidal shape with a height of 100 [nm] or more, and
the light extraction surface includes a -c-plane of the nitride semiconductor.

38. The light-emitting element according to claim 37, wherein the nitride semiconductor base member including the light extraction surface has a threading dislocation density of 5 × 10⁶ dislocations/cm² or less.
